# EUROPEAN PATENT APPLICATION

(11) **EP 4 585 565 A1**
(43) Date of publication of application: **16.07.2025**
(21) Application number: 22958089.9
(22) Date of filing: 07.09.2022
(51) Int. Cl.: C01G 15/00, C04B 35/01, C30B 29/16

(54) **HIGH-PURITY DIGALLIUM TRIOXIDE, AND METHOD FOR PRODUCING SAME**

(71) Applicant: SUMITOMO ELECTRIC INDUSTRIES, LTD., Osaka-shi, Osaka 541-0041 (JP)
(72) Inventor: ISHIKAWA, Yukio, Osaka-shi, Osaka 541-0041 (JP); HAGI, Yoshiaki, Osaka-shi, Osaka 541-0041 (JP)
(74) Representative: Grünecker Patent- und Rechtsanwälte PartG mbB
(86) International application number: PCT/JP2022/033545
(87) International publication number: WO 2024/053010

(57) **Abstract**

This high-purity digallium trioxide comprises digallium trioxide, and one or more impurity elements other than gallium and oxygen, wherein in glow discharge mass spectrometry, the total concentration of the impurity elements is at most 1 mass ppm, and the concentration of silicon, which is one of the impurity elements, is 0.01 mass ppm to 0.1 mass ppm.

## Description

### TECHNICAL FIELD

The present disclosure relates to a high purity digallium trioxide and a method of manufacturing the same.

### BACKGROUND ART

Japanese Unexamined Patent Application Publication No. 2011-153054 (Patent literature 1) discloses a technique for densifying a gallium oxide raw material to be a raw material of a gallium oxide single crystal for the purpose of efficiently manufacturing the gallium oxide single crystal. Examples of the gallium oxide raw material include gallium oxides such as gallium oxide or gallium carbonate which are commercially available, or salts, hydrates thereof, and mixtures thereof. Non-patent literature 1 below discloses gallium oxide containing 6.6 ppm by mass of silicon (Si) as a raw material for manufacturing a gallium oxide single crystal. Non-patent literature 2 below discloses that a gallium oxide single crystal containing 1.0 to 10 ppm by mass of Si was manufactured by a so-called VB method. Non-patent literature 3 below discloses gallium oxide containing 1.7 ppm by mass of silicon (Si) as a raw material for manufacturing a gallium oxide single crystal.

### CITATION LIST

### PATENT LITERATURE

Patent literature 1: Japanese Unexamined Patent Application Publication No. 2011-153054

### NON PATENT LITERATURE

Non-patent literature 1: M. Saleh et al., Semiconductor Science and Technology, Volume 35, Issue 4, id. 04LT01
Non-patent literature 2: K. Hoshikawa et al., Journal of Crystal Growth, Volume 447, 1 August 2016, page 36-41
Non-patent literature 3: A. Kuramata et al., Journal of the Japanese Association for Crystal Growth, Vol. 44, No. 4 (2017) 44-4-02

### SUMMARY OF THE INVENTION

A high purity digallium trioxide according to the present disclosure includes digallium trioxide and one or more impurity elements other than gallium and oxygen. In glow discharge mass spectrometry, a total concentration of the one or more impurity elements is 1 ppm by mass or less, and a concentration of silicon that is one of the one or more impurity elements is 0.01 ppm by mass to 0.1 ppm by mass.

A method of manufacturing a high purity digallium trioxide according to the present disclosure includes: preparing a molten metal gallium; introducing the molten metal gallium into a crucible; disposing a solid boron oxide on the molten metal gallium in the crucible; obtaining a molten boron oxide by heating the crucible; producing digallium trioxide by sealing the molten metal gallium with the molten boron oxide, heating the crucible to a temperature of 1200K to 1600K, and blowing a gas including oxygen into the crucible; and obtaining the digallium trioxide by cleaning a content including the boron oxide and the digallium trioxide in the crucible with an ultrapure water at 60°C or higher.

### BRIEF DESCRIPTION OF THE DRAWINGS

FIG. 1 is a flowchart showing an example of a method of manufacturing a high purity digallium trioxide according to the present embodiment.
FIG. 2 is a schematic view for explaining a manufacturing apparatus used for a method of manufacturing the high purity digallium trioxide according to the present embodiment.

### DETAILED DESCRIPTION

### [Problems to be Solved by Present Disclosure]

As gallium oxide (hereinafter referred to as "digallium trioxide or Ga₂O₃" in the present specification) serving as a raw material of the gallium oxide single crystal, particularly the digallium trioxide single crystal, disclosed in the patent literature 1 and non-patent literatures 1 to 3, a Ga₂O₃ sintered material for a sputtering target manufactured by thermal decomposition of gallium hydroxide has been conventionally used. However, the Ga₂O₃ sintered material is required to have good sinterability, that is, to have fine grains, because it is used for a sputtering target. That is, since the Ga₂O₃ sintered material is composed of fine grains, it is easily contaminated by, for example, adsorption and coprecipitation of an impurity to the surfaces of the Ga₂O₃ grains. For example, the Ga₂O₃ disclosed in the patent literature 1 and non-patent literatures 1 to 3 contains a large amount of Si. According to the research of the present inventors, the upper limit of the purity of such Ga₂O₃ was 99.999% by mass.

In recent years, new applications of Ga₂O₃ as a semiconductive material have been studied, and Ga₂O₃ having a higher purity than before may be required. On the other hand, Ga₂O₃ having an extremely low concentration of impurity elements, such as a purity exceeding 99.9999% by mass, which is generally required for compound semiconductors, has not been obtained yet, and development thereof is desired.

In view of the above, an object of the present disclosure is to provide a high purity digallium trioxide having an extremely low concentration of impurity elements and thus having high purity, and a method of manufacturing the same.

### [Advantageous Effect of the Present Disclosure]

According to the above, it is possible to provide a high purity digallium trioxide having an extremely low concentration of impurity elements and thus having high purity, and a method of manufacturing the same.

### [Overview of Embodiments]

The following is an overview of embodiments of the present disclosure. The present inventors have conducted intensive studies to solve the above problems and completed the present disclosure. First, the present inventors paid attention to obtaining a high purity Ga₂O₃ by reacting high purity metal gallium (Ga) (hereinafter, also referred to as "high purity Ga") with oxygen (O) in an environment in which substantially no foreign matter is mixed. In particular, since GaAs polycrystal used as a material for manufacturing gallium arsenide (GaAs) single crystal has been conventionally manufactured by reacting high purity Ga having a purity of about 99.9999% by mass with arsenide, the inventors have conceived of using the high purity Ga as a material for obtaining the high purity Ga₂O₃. Further, the present inventors have also conceived of avoiding the mixing of foreign matter by sealing the high purity Ga introduced in a vessel with boron oxide (B₂O₃) which hardly reacts with metal Ga. The present inventors have found that the high purity Ga₂O₃ having a purity exceeding 99.9999% by mass can be manufactured from high purity Ga, and have reached the present disclosure.

Next, embodiments of the present disclosure will be listed and described.
[1] A high purity digallium trioxide according to an embodiment of the present disclosure includes digallium trioxide and one or more impurity elements other than gallium and oxygen. In glow discharge mass spectrometry, a total concentration of the one or more impurity elements is 1 ppm by mass or less, and a concentration of silicon that is one of the one or more impurity elements is 0.01 ppm by mass to 0.1 ppm by mass. The Ga₂O₃ having such characteristics has an extremely low concentration of impurity elements, and thus can have high purity.
[2] In the glow discharge mass spectrometry, a concentration of boron that is another one of the one or more impurity elements is preferably 0.01 ppm by mass to 0.5 ppm by mass, and each of concentrations of lithium, sodium, magnesium, aluminum, phosphorus, sulfur, potassium, calcium, chromium, manganese, iron, nickel, copper, zinc, niobium, molybdenum, silver, cadmium, tin, tungsten, lead, and bismuth is preferably less than 0.01 ppm by mass. Thus, the Ga₂O₃ with extremely low concentrations of various impurity elements including boron (B) and with higher purity can be provided.
[3] A purity of the high purity digallium trioxide is preferably 99.99995% by mass or more. Thus, the Ga₂O₃ with higher purity can be provided.
[4] The high purity digallium trioxide is preferably a polycrystal. Thus, the Ga₂O₃ with high purity as a polycrystal can be provided.
[5] In the glow discharge mass spectrometry, the concentration of the silicon is preferably 0.01 ppm by mass to 0.05 ppm by mass. Thus, the high purity Ga₂O₃ having an extremely low Si concentration can be provided.
[6] In the glow discharge mass spectrometry, a concentration of boron that is another one of the one or more impurity elements is preferably 0.01 ppm by mass to 0.2 ppm by mass. Thus, the high purity Ga₂O₃ having an extremely low B concentration can be provided.
[7] A method of manufacturing a high purity digallium trioxide according to an embodiment of the present disclosure includes: preparing a molten metal gallium; introducing the molten metal gallium into a crucible; disposing a solid boron oxide on the molten metal gallium in the crucible; obtaining a molten boron oxide by heating the crucible; producing digallium trioxide by sealing the molten metal gallium with the molten boron oxide, heating the crucible to a temperature of 1200K to 1600K, and blowing a gas including oxygen into the crucible; and obtaining the digallium trioxide by cleaning a content including the boron oxide and the digallium trioxide in the crucible with an ultrapure water at 60°C or higher. By the manufacturing method having such characteristics, the Ga₂O₃ having an extremely low concentration of impurity elements and thus having high purity can be obtained.
[8] The high purity digallium trioxide is preferably a polycrystal. Thus, the Ga₂O₃ polycrystal having high purity can be obtained.
[9] In the producing digallium trioxide, the crucible is preferably heated to a temperature of 1200K to 1400K. Thus, the Ga₂O₃ with higher purity can be obtained.
[10] The gas including oxygen is preferably a mixed gas consisting of 10% by mass or more of oxygen and a remainder of nitrogen, or a pure oxygen. Thus, the Ga₂O₃ with high purity can be obtained with high yield.
[11] A purity of the metal gallium is preferably 99.9999% by mass or more. Thus, the Ga₂O₃ with high purity can be obtained with high yield.
[12] A purity of the boron oxide is preferably 99.999% by mass or more. Thus, the Ga₂O₃ with high purity can be obtained with high yield.

### [Details of Embodiments]

Hereinafter, an embodiment according to the present disclosure (hereinafter, also referred to as "the present embodiment") will be described in more detail, but the present disclosure is not limited thereto. The following description may be made with reference to the drawings. In the present description and the drawings, the same or corresponding elements are denoted by the same reference numerals, and the same description thereof will not be repeated. In the drawings, the scale of each component is appropriately adjusted for easy understanding of the components, and the scale of each component illustrated in the drawings does not necessarily coincide with the scale of an actual component.

In the present specification, the notation in the form of "A to B" means a lower limit and an upper limit of a range (that is, A or more and B or less), and when there is no description of a unit for A and a unit is described only for B, the unit of A and the unit of B are the same. Further, in the present specification, when a compound or the like is represented by a chemical formula, any conventionally known atomic ratio is included unless the atomic ratio is particularly limited, and the compound or the like should not necessarily be limited only to a stoichiometric range.

### [High purity digallium trioxide (Ga₂O₃)]

A high purity digallium trioxide (Ga₂O₃) according to the present embodiment has the following characteristics. That is, the high purity Ga₂O₃ includes Ga₂O₃ and one or more impurity elements other than gallium (Ga) and oxygen (O). In glow discharge mass spectrometry (GDMS), a total concentration of the impurity elements is 1 ppm by mass or less, and a concentration of silicon (Si) that is one of the impurity elements is 0.01 ppm by mass to 0.1 ppm by mass. In particular, a purity of the high purity Ga₂O₃ is preferably 99.99995% by mass or more. The purity of the high purity Ga₂O₃ is more preferably 99.99998% by mass or more. The high purity Ga₂O₃ having such characteristics has an extremely low concentration of impurity elements, and thus can have high purity. The high purity Ga₂O₃ contains Ga₂O₃ at an extremely high purity, in other words, it can be said that the high purity Ga₂O₃ is a composition containing Ga₂O₃ and one or more impurity elements other than Ga and O.

### <Polycrystal>

The high purity Ga₂O₃ is preferably a polycrystal. This is because the high purity Ga₂O₃ is coarse grains, and thus can prevent contamination due to an increase in specific surface area. In particular, the high purity Ga₂O₃ preferably has an average grain size of 1 µm or more at least in the crystalline grains constituting the polycrystal. Further, the high purity Ga₂O₃ may be a single crystal. When the purity of the high purity Ga₂O₃ exceeds 99.9999% by mass, the average grain size may be less than 1 µm.

When the high purity Ga₂O₃ is a polycrystal, the average grain size of the crystalline grains constituting the polycrystal can be directly measured by using a scanning electron microscope (SEM). First, for example, according to the method of manufacturing the high purity Ga₂O₃ described later, a powder of the high purity Ga₂O₃ to be measured is obtained. Next, the powder is directly attached to a conductive tape, and the grain size of the high purity Ga₂O₃ on the conductive tape is observed by SEM. In this case, the measurement conditions can be set to an acceleration voltage of 5 kV and an observation magnification of 10,000 times. The grain size of at least 100 Ga₂O₃ grains present on the conductive tape is measured, and the average value thereof can be determined as the average grain size of the crystalline grains constituting the polycrystal.

### <Concentration of impurity elements other than gallium (Ga) and oxygen (O)>

The high purity Ga₂O₃ contains Ga₂O₃ and one or more impurity elements other than gallium (Ga) and oxygen (O) as described above. In the high purity Ga₂O₃, in the GDMS, a total concentration of the impurity elements other than Ga and O is 1 ppm by mass or less, and a concentration of Si that is one of the impurity elements is 0.01 ppm by mass to 0.1 ppm by mass. When the total concentration of impurity elements other than Ga and O in the high purity Ga₂O₃ exceeds 1 ppm by mass or when the concentration of Si exceeds 0.1 ppm by mass, it is difficult to obtain the high purity Ga₂O₃ having a desired high purity intended by the present disclosure.

The high purity Ga₂O₃ preferably has the following characteristics. That is, in the GDMS, the concentration of Si is preferably 0.01 ppm by mass to 0.05 ppm by mass. In the GDMS, a concentration of boron (B) that is another one of the impurity elements is preferably 0.01 ppm by mass to 0.5 ppm by mass, and each of concentrations of lithium (Li), sodium (Na), magnesium (Mg), aluminum (Al), phosphorus (P), sulfur (S), potassium (K), calcium (Ca), chromium (Cr), manganese (Mn), iron (Fe), nickel (Ni), copper (Cu), zinc (Zn), niobium (Nb), molybdenum (Mo), silver (Ag), cadmium (Cd), tin (Sn), tungsten (W), lead (Pb), and bismuth (Bi) is preferably less than 0.01 ppm by mass. In particular, in the GDMS, the concentration of B is preferably 0.01 ppm by mass to 0.2 ppm by mass. Thus, the high purity Ga₂O₃ has extremely low concentrations of various impurity elements including Si and B, and thus can have higher purity.

Here, the fact that each of concentrations of the above-mentioned various impurity elements other than Ga and O is less than 0.01 ppm by mass in the above-mentioned high purity Ga₂O₃ means that each of the concentrations are less than the detection lower limit in the GDMS. In other words, the preferred embodiment of the high purity Ga₂O₃ means that Li, Na, Mg, Al, P, S, K, Ca, Cr, Mn, Fe, Ni, Cu, Zn, Nb, Mo, Ag, Cd, Sn, W, Pb and Bi are not detected in the GDMS. In the high purity Ga₂O₃, it is further preferred that each of various impurity elements of cesium (Cs), barium (Ba), lanthanum (La), cerium (Ce), praseodymium (Pr), neodymium (Nd), samarium (Sm), europium (Eu), gadolinium (Gd), terbium (Yb), dysprosium (Dy), holmium (Ho), erbium (Er), thulium (Tm), ytterbium (Yb), hafnium (Hf), gold (Au), mercury (Hg), thorium (Th), uranium (U), beryllium (Be), scandium (Sc), titanium (Ti), vanadium (V), cobalt (Co), germanium (Ge), arsenic (As), selenium (Se), strontium (Sr), yttrium (Y), zirconium (Zr), antimony (Sb), iodine (I) and tellurium (Te) is also less than the lower detection limit in the GDMS.

### <Glow discharge mass spectrometry (GDMS)>

Hereinafter, a composition analysis method of the high purity Ga₂O₃ using glow discharge mass spectrometry (GDMS) will be described. GDMS is a technique in which glow discharge plasma is generated using an analysis sample as a cathode in a high purity argon atmosphere, and the surface of the analysis sample is sputtered in the plasma, thereby measuring ionized constituent elements in the analysis sample with a mass spectrometer. Thus, the impurity elements other than Ga and O contained in the high purity Ga₂O₃ can be qualitatively and quantitatively determined. Further, the purity of the high purity Ga₂O₃ can be determined. As the ion source of the GDMS, two types of cells, a flat cell and a pin-shaped cell, can be used. The pin-shaped cell can be applied to an analysis sample that can be formed into a strip shape having a substantially 2 mm square and a substantially 20 mm long. Specifically, it is used when analyzing a Si single crystal, a gallium arsenide (GaAs) single crystal, an indium phosphide (InP) single crystal, or the like, which can be formed into a sample by cleavage. The flat cell can be applied to an analysis sample that can be formed into a disk shape having about 10 mm in diameter, and is used when analyzing, for example, a polycrystal. In the composition analysis of the high purity Ga₂O₃, the flat cell is preferably used. In the case of using the flat cell, by using an auxiliary electrode of high purity indium (In) as described later, discharge plasma can be generated even in an oxide polycrystal or the like which is an insulator, and thus GDMS can be performed.

The GDMS can be performed, for example, in the following manner. First, the high purity Ga₂O₃ is obtained by the manufacturing method described later. The high purity Ga₂O₃ can be, for example, a polycrystal. Next, the polycrystal of the high purity Ga₂O₃ is applied to a sample-disposed portion (circular shape with a diameter of 10 mm, that is, corresponding to a discharge area) on an auxiliary electrode of high purity indium attached to a spectrometry apparatus described later. Here, it is preferable that the sample-disposed portion is cleaned by a conventional method and pre-sputtered for 60 minutes for the purpose of preventing the mixing of foreign matter and removing the foreign matter before the polycrystal of the high purity Ga₂O₃ is applied. The analysis value at the time of pre-sputtering becomes the background.

Next, GDMS can be performed on the polycrystal of the high purity Ga₂O₃ applied to the sample-disposed surface of the high purity indium under the following conditions. Note that, for the impurity elements other than Ga and O among the constituent elements in the analysis sample and In of the auxiliary electrode, the semi-quantitative value can be calculated by correcting the ion intensity ratio between Ga and each of the elements in the impurity elements with the relative sensitivity factor (RSF). In the present specification, "impurity elements" means all elements other than Ga and O, which can be analyzed by the GDMS.
Apparatus: Glow discharge mass spectrometry apparatus (trade name (product number): VG-9000, manufactured by VG Elemental Inc.)
Ion source: Flat cell (cooled with liquid nitrogen during analysis)
Discharge area: 10 mm in diameter
Discharge gas: High purity argon (6N grade)
Discharge conditions: 2 mA, 1 kV (constant current mode)
Detector: Faraday cup and multiplier
Mass resolution: 4000 or more m/Δm (high resolution mode).

As described above, the composition analysis of the high purity Ga₂O₃ is performed, and thus, the impurity elements other than Ga and O contained in the high purity Ga₂O₃ can be qualitatively and quantitatively determined. Further, the purity of the high purity Ga₂O₃ can be determined based on the result of quantification of the impurity elements. In the present specification, "purity" of the high purity Ga₂O₃ is represented by a numerical value to the fifth decimal place by rounding off the sixth decimal place, since the detection lower limit concentration of the GDMS is 0.01 ppm. The purities of metal gallium and boron oxide, which will be described later, can also be determined in the same manner as the composition analysis method of the high purity Ga₂O₃. In the GDMS of metal gallium, the high purity indium serving as the auxiliary electrodes is not required, and the analysis can be performed by casting a disc-shaped analysis sample having a diameter of 20 mm.

### [Method of manufacturing digallium trioxide]

A method of manufacturing a high purity digallium trioxide (Ga₂O₃) according to the present embodiment can be, for example, a method of manufacturing the high purity Ga₂O₃ having the above-described characteristics. That is, the method of manufacturing the high purity Ga₂O₃ includes: a step of preparing a molten metal gallium (metal Ga); a step of introducing the molten metal Ga into a crucible; a step of disposing a solid boron oxide (B₂O₃) on the molten metal Ga in the crucible; obtaining a molten B₂O₃ by heating the crucible; a step of producing Ga₂O₃ by sealing the molten metal Ga with the molten B₂O₃, heating the crucible to a temperature of 1200K to 1600K, and blowing a gas including oxygen (O) into the crucible; and a step of obtaining the Ga₂O₃ by cleaning a content including the B₂O₃ and the Ga₂O₃ in the crucible with an ultrapure water at 60°C or higher. By the manufacturing method having such characteristics, the Ga₂O₃ having an extremely low concentration of impurity elements and thus having high purity can be obtained.

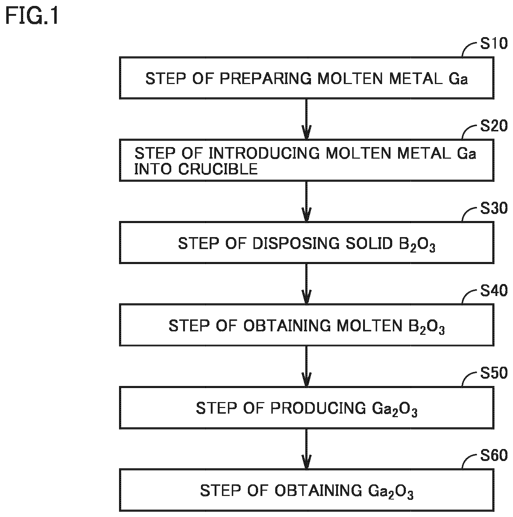

Specifically, the manufacturing method preferably includes steps as shown in the flowchart of FIG. 1, for example. FIG. 1 is a flowchart showing an example of a method of manufacturing a high purity digallium trioxide according to the present embodiment. According to FIG. 1, the method of manufacturing a high purity Ga₂O₃ may include: a step S10 (first step) of preparing a molten metal Ga; a step S20 (second step) of introducing the molten metal Ga into a crucible; a step S30 (third step) of disposing a solid B₂O₃ on the molten metal Ga in the crucible; a step S40 (fourth step) of obtaining a molten B₂O₃ by heating the crucible; a step S50 (fifth step) of producing Ga₂O₃ by sealing the molten metal Ga with the molten B₂O₃, heating the crucible to a temperature of 1200K to 1600K, and blowing a gas including O into the crucible; and a step S60 (sixth step) of obtaining the Ga₂O₃ by cleaning a content including the B₂O₃ and the Ga₂O₃ in the crucible with an ultrapure water at 60°C or higher.

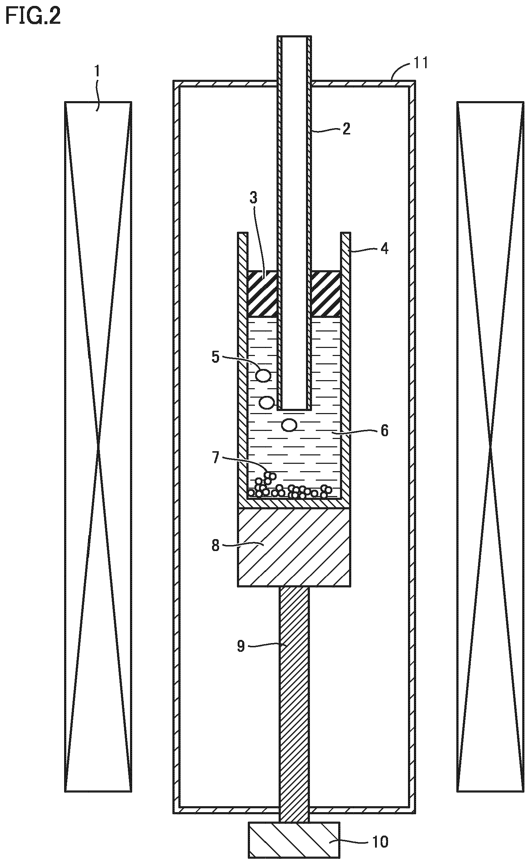

In particular, in the method of manufacturing the high purity Ga₂O₃, in step S50 of producing the Ga₂O₃, the crucible is preferably heated to a temperature of 1200K to 1400K. Further, the gas including O is preferably a mixed gas consisting of 10% by mass or more of O and a remainder of nitrogen (N), or a pure oxygen. The high purity Ga₂O₃ obtained by the above manufacturing method is preferably a polycrystal. The present inventors have conceived that high purity Ga of about 99.9999% by mass, which is used as a material of GaAs polycrystal for manufacturing GaAs single crystal as described above, is sealed with Ga₂O₃ which does not react with metal Ga, and then reacted with O, thereby obtaining the high purity Ga₂O₃. It was found that the high purity Ga₂O₃ having a purity exceeding 99.9999% by mass can be manufactured from the above high purity Ga. Hereinafter, an overview of a manufacturing apparatus used in the above manufacturing method and details of the above method of manufacturing the high purity Ga₂O₃ will be described with reference to FIGS. 1 and 2.

### <Manufacturing apparatus>

FIG. 2 is a schematic view for explaining a manufacturing apparatus used for a method of manufacturing the high purity digallium trioxide according to the present embodiment. In the method of manufacturing the high purity Ga₂O₃ according to the present embodiment, the high purity Ga₂O₃ can be manufactured by using the manufacturing apparatus shown in FIG. 2, for example. The manufacturing apparatus shown in FIG. 2 includes at least a crucible 4, a crucible-holding stage 8 for holding crucible 4, a lower shaft 9 for supporting crucible 4 and crucible-holding stage 8, a load cell 10 capable of monitoring the progress of the Ga₂O₃ synthesis reaction by detecting the weight of the content in crucible 4, and heater 1 for heating crucible 4. The manufacturing apparatus further includes a gas introducing tube 2 for introducing a gas 5 including O into crucible 4 from the outside. The manufacturing apparatus may include a container 11 for accommodating crucible 4, the content thereof, crucible-holding stage 8, and lower shaft 9 in order to avoid the mixing of foreign matters from the outside. Container 11 can be used without any particular limitation on size and the like as long as it is a vessel that can avoid the mixing of foreign matters from the outside, can accommodate the above-described components such as crucible 4, and is made of a material having good heat permeability to the heat from heater 1.

### (Crucible)

Crucible 4 can function as a site for reacting a molten metal Ga 6 with gas 5 including O in order to obtain a high purity Ga₂O₃ 7. Crucible 4 can employ a variety of materials that can withstand the temperature (in particular, 1200 to 1600K, that is, 927 to 1327°C) at which molten metal Ga 6 and gas 5 including O are reacted. For example, pyrolytic boron nitride (pBN) can be employed as the material of crucible 4. Crucible 4 is, in particular, cylindrical and can accommodate molten metal Ga 6 and can accommodate a solid B₂O₃ by disposing a solid B₂O₃ on molten metal Ga 6. An inside diameter of crucible 4 can be, for example, 75 mm to 150 mm. The solid B₂O₃ can be formed into a molten B₂O₃ 3 by heating crucible 4 with heater 1 described later.

### (Crucible-holding stage)

Crucible-holding stage 8 holds crucible 4 in contact with the bottom of crucible 4. Crucible-holding stage 8 may have a cylindrical appearance. A material of crucible-holding stage 8 is not particularly limited, and quartz, alumina, silicon carbide, or the like can be employed, for example.

### (Lower shaft)

Lower shaft 9 can support crucible 4 and crucible-holding stage 8 by supporting crucible-holding stage 8 from below. Lower shaft 9 may be formed in a rod shape which is circular in a horizontal cross-section view or rectangular in a horizontal cross-section view, for example. As a material of lower shaft 9, molybdenum, carbon, silicon carbide, or the like can be employed, for example.

### (Load cell)

Load cell 10 is disposed so as to support lower shaft 9 from below. Thus, load cell 10 can detect that the content in crucible 4 is increased in weight as Ga₂O₃ 7 is produced from molten metal Ga 6 in step S50 of producing the Ga₂O₃ to be described later. Load cell 10 detects the weight of the content, and thus the progress of the Ga₂O₃ synthesis reaction can be monitored in the manufacturing apparatus. Load cell 10 can be prepared by, for example, being obtained from the market.

### (Heater)

Heater 1 is installed for the purpose of heating crucible 4. Heater 1 is arranged in two pieces so as to surround the outer periphery of crucible 4. The output of heater 1 can be controlled independently for each piece. In particular, heater 1 may be configured in multiple stages by dividing each piece into a plurality of parts in a direction perpendicular to the axis of crucible 4. In this case, the output of heater 1 can be controlled independently for each of the parts configured in multiple stages, and thus the temperature of the content in crucible 4 can be adjusted along the axial direction of crucible 4. Heater 1, for example, can employ a known electric heater.

Although not shown, the manufacturing apparatus may include a thermocouple capable of measuring the temperature of crucible 4 heated by heater 1. A plurality of thermocouples may be disposed outside crucible 4 and along the axial direction. As the thermocouple, for example, a known temperature monitor can be employed.

### (Gas introducing tube)

Gas introducing tube 2 is a tube for introducing gas 5 including O into crucible 4 from the outside. By introducing gas 5 including O into crucible 4 by gas introducing tube 2, metal Ga 6 melted in crucible 4 and gas 5 including O are reacted, and thus, high purity Ga₂O₃ 7 can be obtained. A material of gas introducing tube 2 is not particularly limited, but is preferably a material which does not react with oxygen or metal Ga, and for example, quartz or pBN coated carbon can be employed.

### <Details of method of manufacturing high purity Ga₂O₃ (Each step included in method of manufacturing high purity Ga₂O₃)>

### (First step: step S10 of preparing molten metal Ga)

According to the method of manufacturing the high purity Ga₂O₃ according to the present embodiment, high purity Ga₂O₃ 7 can be obtained by performing the following steps as shown in FIG. 1. In the above-described manufacturing method, first, S10 of preparing the molten metal Ga is performed as a first step. In the first step, specifically, a solid metal Ga obtained from the market is melted in a thermostatic bath at a temperature equal to or higher than the melting point of Ga (for example, 30°C or higher), whereby the molten metal Ga can be prepared. In particular, in this step, it is preferable to use a high purity metal Ga of 6N grade that can be obtained from the market. That is, the purity of the metal gallium is preferably 99.9999% by mass or more. Since the high purity metal Ga of 6N grade can be obtained from the market in a state of being accommodated in a vessel made of polyethylene, for example, the molten metal Ga can be prepared by putting the vessel made of polyethylene into the thermostatic bath.

### (Second step: step S20 of introducing molten metal Ga into crucible)

Next, as a second step, step S20 of introducing the molten metal Ga into a crucible is performed. In the second step, specifically, molten metal Ga 6 in the vessel made of polyethylene prepared in the first step can be introduced into crucible 4 while avoiding the mixing of foreign matter from the outside. As such an introduction method, a conventionally known method can be used.

### (Third step: step S30 of disposing solid B₂O₃)

Next, as a third step, step S30 of disposing a solid B₂O₃ on the molten metal Ga in the crucible is performed. In the third step, specifically, the solid B₂O₃ can be disposed on molten metal Ga 6 introduced in crucible 4 in the second step. As a method of disposing the solid B₂O₃, a conventionally known method can be used. Here, as for the solid B₂O₃, it is preferable to use 5N grade in order to obtain high purity Ga₂O₃ 7. That is, the purity of the B₂O₃ is preferably 99.999% by mass or more. Such high purity B₂O₃ can be obtained from the market and can be produced by a conventionally known method.

### (Fourth step: step S40 of obtaining molten B₂O₃)

Next, as a fourth step, step S40 of obtaining a molten B₂O₃ by heating the crucible is performed. In the fourth step, specifically, the B₂O₃ can be melted by heating crucible 4 with heater 1 to raise the temperature in crucible 4 to a temperature equal to or higher than the melting point of the B₂O₃ (for example, 500°C or higher). This provides molten B₂O₃ 3 which can be used as a liquid sealing material in the next step.

### (Fifth step: step S50 of producing Ga₂O₃)

Next, as a fifth step, step S50 of producing the Ga₂O₃ by sealing the molten metal Ga with the molten B₂O₃, heating the crucible to a temperature of 1200K to 1600K, and blowing a gas including O into the crucible is performed. In the fifth step, molten metal Ga 6 is sealed with molten B₂O₃ 3 melted in the fourth step, so that the molten B₂O₃ 3 functions as a liquid sealing material. This can prevent foreign matter from entering metal Ga 6 in crucible 4 from the outside. Subsequently, gas introducing tube 2 is inserted into crucible 4 until a tip of gas introducing tube 2 extends through molten B₂O₃ 3 and reaches molten metal Ga 6. Further, crucible 4 is heated by heater 1 so that the temperature in crucible 4 is 1200K to 1600K, that is, 927 to 1327°C, which is a temperature at which byproducts other than the Ga₂O₃ produced by the reaction between metal Ga and O are unlikely to be generated. Further, gas 5 including O is blown into crucible 4 from the outside through gas introducing tube 2. Thus, metal Ga and O are reacted in crucible 4 to produce the Ga₂O₃. In step S50 of producing the Ga₂O₃, the crucible is preferably heated to a temperature of 1200K to 1400K.

Gas 5 including O is preferably a mixed gas consisting of 10% by mass or more of oxygen and a remainder of nitrogen, or a pure oxygen, for the purpose of efficiently producing the Ga₂O₃. The flow rate of gas 5 including O blown into crucible 4 through gas introducing tube 2 is preferably 10 to 1000 mL/min. In this step, molten B₂O₃ 3 functions as the liquid sealing material on molten metal Ga 6, and thus O in gas 5 including O can be consumed for the reaction with metal Ga without leaking to the outside of crucible 4. In particular, by detecting the increase in weight of the content in crucible 4 in the Ga₂O₃ production using load cell 10 and monitoring the progress of the reaction between metal Ga and O, O in gas 5 including O can be reacted with 99% by mass or more of metal Ga, thereby efficiently producing Ga₂O₃ 7. For example, according to this step, Ga₂O₃ 7 can be produced from molten metal Ga 6 at a yield of 99% by mass or more. In the present specification, the "yield" of the Ga₂O₃ means the ratio of the amount of the Ga₂O₃ actually obtained to the amount of the Ga₂O₃ theoretically obtained in the case where the Ga₂O₃ is obtained from metal Ga by chemical reaction, and is expressed in percentage.

### (Sixth step: step S60 of obtaining Ga₂O₃)

Finally, as a sixth step, step S60 of obtaining the Ga₂O₃ by cleaning a content including the B₂O₃ and the Ga₂O₃ in the crucible with an ultrapure water at 60°C or higher is performed. In the sixth step, first, after it is confirmed by load cell 10 that the progress of the reaction between metal Ga and O has reached 99% or more, for example, the introduction of gas 5 including O into crucible 4 through gas introducing tube 2 is stopped. Further, crucible 4 heated in the fifth step is cooled by an appropriate method until the temperature of crucible 4 reaches room temperature so that crucible 4 can be handled by a human hand. Subsequently, crucible 4 accommodating the content including Ga₂O₃ 7 and the B₂O₃ produced in the fifth step is put into ultrapure water at 60°C or higher to clean the content containing Ga₂O₃ 7 and the B₂O₃. At this time, since the B₂O₃ is dissolved in the ultrapure water, only Ga₂O₃ 7 can be recovered by removing the ultrapure water. As described above, Ga₂O₃ 7 can be obtained from the content in crucible 4. In the present specification, "ultrapure water" refers to pure water having an electric resistivity (specific resistance) of 15 MΩ·cm or more, a total organic carbon (TOC) of less than 50 µg/L, and a fine particle count of less than 100 particles/L.

### <Function and effect>

By performing the above steps, high purity Ga₂O₃ 7 can be manufactured. In the method of manufacturing the high purity Ga₂O₃ according to the present embodiment, in particular, in the fifth step, molten metal Ga 6 is sealed with molten B₂O₃ 3, crucible 4 is heated to 1200 to 1600K, which is a temperature at which byproducts other than Ga₂O₃ are unlikely to be generated, and then gas 5 including O is blown into crucible 4 to react metal Ga with O, thereby producing Ga₂O₃ 7. Thus, the high purity Ga₂O₃ (for example, Ga₂O₃ having a total concentration of impurity elements other than Ga and O of 1 ppm by mass or less and a concentration of Si of 0.01 ppm by mass to 0.1 ppm by mass) can be efficiently obtained from the high purity metal Ga while preventing the mixing of foreign matter from the outside. Thus, according to the present manufacturing method, the high purity Ga₂O₃ having a very low concentration of impurity elements and high purity can be obtained.

### EXAMPLES

The present disclosure will be described in more detail with reference to the following examples, but the present disclosure is not limited thereto. In this example, the high purity digallium trioxide (high purity Ga₂O₃) was manufactured according to the flowchart shown in FIG. 1 using the manufacturing apparatus shown in FIG. 2. In the following description, Sample 1 to Sample 2 are examples, and Sample 11 to Sample 14 are comparative examples.

### [Manufacturing of Ga₂O₃]

### <Sample 1>

### (First step)

A commercially available 6N grade (purity: 99.99995% by mass or more) high purity metal Ga (manufactured by Rasa Industries, Ltd.) 10 kg was prepared by obtaining it. Since the high purity metal Ga was accommodated in a polyethylene vessel, the polyethylene vessel was put into a thermostatic bath at 60°C to obtain the molten metal Ga.

### (Second step)

Molten metal Ga 6 in the polyethylene vessel was introduced into crucible 4 having an inner diameter of 100 mm by a known method while avoiding the mixing of foreign matter from the outside. A height of molten metal Ga 6 in crucible 4 was 209 mm.

### (Third step)

Subsequently, 500 g of a commercially available solid B₂O₃ (manufactured by Rasa Industries, Ltd.) was disposed on molten metal Ga 6 in crucible 4 by a conventionally known method. The purity of the solid B₂O₃ was confirmed to be 99.999% by mass by product labeling.

### (Fourth step)

Next, crucible 4 was heated by heater 1, and the temperature in crucible 4 was set to 800°C which is a temperature equal to or higher than the melting temperature of B₂O₃, thereby melting the solid B₂O₃. As a result, molten B₂O₃ 3 was obtained on molten metal Ga 6 in crucible 4.

### (Fifth step)

First, molten metal Ga 6 was sealed with molten B₂O₃ 3 in the fourth step. Further, a tip of gas introducing tube 2 was inserted into molten metal Ga 6, extending through molten B₂O₃ 3. Crucible 4 was heated by heater 1 so that the temperature in crucible 4 became 1200K. Further, a pure oxygen was blown into crucible 4 from the outside through gas introducing tube 2 as gas 5 including O at a flow rate of 10 mL/min, whereby O in gas 5 including O was reacted with metal Ga 6 to produce Ga₂O₃ 7. In addition, in accordance with the increase in the amount of Ga₂O₃ 7 produced, the position of the tip of gas introducing tube 2 inserted into molten metal Ga 6 was adjusted, for example, so that O in gas 5 including O and metal Ga 6 were reacted as much as possible.

### (Sixth step)

First, after confirming that the reaction rate of the Ga₂O₃, that is, the progress of the reaction between O in gas 5 including O and metal Ga 6 reached 99% or more based on the detection of load cell 10, the introduction of gas 5 including O into crucible 4 through gas introducing tube 2 was stopped. Crucible 4 heated in the fifth step was cooled by air cooling at a rate of 200°C/hour until the temperature of crucible 4 reached room temperature. Subsequently, crucible 4 accommodating the content containing Ga₂O₃ 7 and molten B₂O₃ 3 produced in the fifth step was put into ultrapure water at 60°C to clean the content including Ga₂O₃ 7 and molten B₂O₃ 3. Further, Ga₂O₃ 7 was recovered by removing the ultrapure water. In this manner, a polycrystalline Ga₂O₃ of Sample 1 was obtained.

### <Sample 2>

Ga₂O₃ of Sample 2 was obtained in the same manner as in Sample 1 except that crucible 4 was heated by heater 1 so that the temperature in crucible 4 became 1600K in the fifth step.

### <Sample 11>

A polycrystalline Ga₂O₃ of Sample 11 was obtained by obtaining commercially available Ga₂O₃ (purity 99.999% by mass, manufactured by Zhuzhou Keneng New Material Co., Ltd.).

### <Sample 12>

A polycrystalline Ga₂O₃ of Sample 12 was obtained in the same manner as in Sample 1 except that crucible 4 was heated by heater 1 so that the temperature in crucible 4 became 1150K in the fifth step.

### <Sample 13>

A polycrystalline Ga₂O₃ of Sample 13 was obtained in the same manner as in Sample 1 except that crucible 4 was heated by heater 1 so that the temperature in crucible 4 became 1650K in the fifth step.

### <Sample 14>

A polycrystalline Ga₂O₃ of Sample 14 was obtained in the same manner as in Sample 1 except that the fourth step, the fifth step, and the sixth step were performed without disposing a solid B₂O₃ (manufactured by Rasa Industries, Ltd.) on molten metal Ga 6 in crucible 4 in the third step.

### [Composition analysis by GDMS]

The Ga₂O₃ of each of Samples 1 to 2 and Samples 11 to 14 was subjected to the composition analysis method using GDMS described above to identify impurity elements, which are elements other than Ga and O contained in the Ga₂O₃, and to measure the concentration thereof. The results are shown in Table 1. The unit of concentration of each element shown in Table 1 is ppm by mass. In addition, "<0.01" in Table 1 means that the concentration was equal to or less than the detection lower limit.

### [Table 1]

**Table 1**

| | Sample 1 | Sample 2 | Sample 11 | Sample 12 | Sample 13 | Sample 14 |
|---|---|---|---|---|---|---|
| Si | 0.02 | 0.05 | 1.40 | 0.05 | 0.43 | 1.20 |
| B | 0.12 | 0.50 | 0.10 | 5.00 | 0.50 | 0.10 |
| Li | <0.01 | <0.01 | 0.03 | <0.01 | <0.01 | 0.03 |
| Na | <0.01 | <0.01 | 0.08 | <0.01 | <0.01 | 0.02 |
| Mg | <0.01 | <0.01 | 0.02 | <0.01 | <0.01 | 0.02 |
| Al | <0.01 | <0.01 | 0.70 | <0.01 | <0.01 | 0.70 |
| P | <0.01 | <0.01 | 0.12 | <0.01 | <0.01 | 0.12 |
| S | <0.01 | <0.01 | 0.35 | <0.01 | <0.01 | 0.35 |
| K | <0.01 | <0.01 | 0.12 | <0.01 | <0.01 | 0.12 |
| Ca | <0.01 | <0.01 | 0.08 | <0.01 | <0.01 | 0.10 |
| Cr | <0.01 | <0.01 | 0.18 | <0.01 | <0.01 | 0.18 |
| Mn | <0.01 | <0.01 | 0.02 | <0.01 | <0.01 | 0.02 |
| Fe | <0.01 | <0.01 | 0.72 | <0.01 | <0.01 | 1.00 |
| Ni | <0.01 | <0.01 | 0.14 | <0.01 | <0.01 | 0.14 |
| Cu | <0.01 | <0.01 | 0.40 | <0.01 | <0.01 | 0.40 |
| Zn | <0.01 | <0.01 | 0.02 | <0.01 | <0.01 | 0.02 |
| Nb | <0.01 | <0.01 | 0.02 | <0.01 | <0.01 | 0.02 |
| Mo | <0.01 | <0.01 | 0.02 | <0.01 | <0.01 | 0.02 |
| Ag | <0.01 | <0.01 | 0.03 | <0.01 | <0.01 | 0.03 |
| Cd | <0.01 | <0.01 | 0.10 | <0.01 | <0.01 | 0.10 |
| Sn | <0.01 | <0.01 | 0.05 | <0.01 | <0.01 | 0.05 |
| W | <0.01 | <0.01 | 0.03 | <0.01 | <0.01 | 0.14 |
| Pb | <0.01 | <0.01 | 0.14 | <0.01 | <0.01 | 0.14 |
| Bi | <0.01 | <0.01 | 0.01 | <0.01 | <0.01 | 0.01 |
| Purity (mass%) | 99.99998 | 99.99995 | 99.99950 | 99.99950 | 99.99990 | 99.99950 |
| Yield (mass%) | 99.5 | 99.0 | - | 99.5 | 95.0 | 80.0 |

### [Analysis]

According to Table 1, the Ga₂O₃ of each of Sample 1 and Sample 2 had a total concentration of impurity elements other than Ga and O of 1 ppm by mass or less (Sample 1: 0.14 ppm by mass, Sample 2: 0.55 ppm by mass). Further, a concentration of silicon that is one of the impurity elements was 0.01 ppm by mass to 0.1 ppm by mass (Sample 1: 0.02 ppm by mass, Sample 2: 0.05 ppm by mass). Thus, the purity of the Ga₂O₃ of each of Sample 1 and Sample 2 was 99.99995% by mass or more.

On the other hand, the Ga₂O₃ of each of Samples 11 to 12 and 14 had a total concentration of impurity elements other than Ga and O exceeding 1 ppm by mass, or a concentration of silicon that is one of the impurity elements exceeding 0.1 ppm by mass. The Ga₂O₃ of Sample 13 was produced by reacting metal Ga and O at a temperature exceeding 1600K, and thus part of the produced Ga₂O₃ was dissolved in the B₂O₃ and disappeared. Thus, the yield was lower than that of Samples 1 and 2. The content of impurity elements increased accordingly, and the concentration of silicon that is one of the impurity elements became 0.43 ppm by mass.

Although the embodiments and examples of the present disclosure have been described above, it is originally intended to appropriately combine the constitutions of the above-described embodiments and examples.

The embodiments and examples disclosed herein are illustrative in all respects and should not be construed as limiting. The scope of the present invention is defined by the appended claims rather than the foregoing embodiments and examples, and is intended to include all modifications within the scope and meaning equivalent to the appended claims.

### REFERENCE SIGNS LIST

1 heater, 2 gas introducing tube, 3 molten boron oxide (B₂O₃), 4 crucible, 5 gas including oxygen (O), 6 molten gallium (Ga) metal, 7 digallium trioxide (Ga₂O₃), 8 crucible-holding stage, 9 lower shaft, 10 load cell, 11 container, S10 step of preparing molten metal Ga, S20 step of introducing molten metal Ga into crucible, S30 step of disposing solid B₂O₃, S40 step of obtaining molten B₂O₃, S50 step of producing Ga₂O₃, S60 step of obtaining Ga₂O₃.

## Claims

1. A high purity digallium trioxide comprising:
digallium trioxide and one or more impurity elements other than gallium and oxygen,
wherein, in glow discharge mass spectrometry, a total concentration of the one or more impurity elements is 1 ppm by mass or less, and a concentration of silicon that is one of the one or more impurity elements is 0.01 ppm by mass to 0.1 ppm by mass.

2. The high purity digallium trioxide according to claim 1, wherein, in the glow discharge mass spectrometry, a concentration of boron that is another one of the one or more impurity elements is 0.01 ppm by mass to 0.5 ppm by mass, and each of concentrations of lithium, sodium, magnesium, aluminum, phosphorus, sulfur, potassium, calcium, chromium, manganese, iron, nickel, copper, zinc, niobium, molybdenum, silver, cadmium, tin, tungsten, lead, and bismuth is less than 0.01 ppm by mass.

3. The high purity digallium trioxide according to claim 1 or 2, wherein a purity of the high purity digallium trioxide is 99.99995% by mass or more.

4. The high purity digallium trioxide according to any one of claims 1 to 3, wherein the high purity digallium trioxide is a polycrystal.

5. The high purity digallium trioxide according to any one of claims 1 to 4, wherein, in the glow discharge mass spectrometry, the concentration of the silicon is 0.01 ppm by mass to 0.05 ppm by mass.

6. The high purity digallium trioxide according to any one of claims 1 to 5, wherein, in the glow discharge mass spectrometry, a concentration of boron that is another one of the one or more impurity elements is 0.01 ppm by mass to 0.2 ppm by mass.

7. A method of manufacturing a high purity digallium trioxide, the method comprising:
preparing a molten metal gallium;
introducing the molten metal gallium into a crucible;
disposing a solid boron oxide on the molten metal gallium in the crucible;
obtaining a molten boron oxide by heating the crucible;
producing digallium trioxide by sealing the molten metal gallium with the molten boron oxide, heating the crucible to a temperature of 1200K to 1600K, and blowing a gas including oxygen into the crucible; and
obtaining the digallium trioxide by cleaning a content including the boron oxide and the digallium trioxide in the crucible with an ultrapure water at 60°C or higher.

8. The method of manufacturing a high purity digallium trioxide according to claim 7, wherein the high purity digallium trioxide is a polycrystal.

9. The method of manufacturing a high purity digallium trioxide according to claim 7 or 8, wherein, in the producing digallium trioxide, the crucible is heated to a temperature of 1200K to 1400K.

10. The method of manufacturing a high purity digallium trioxide according to any one of claims 7 to 9, wherein the gas including oxygen is a mixed gas consisting of 10% by mass or more of oxygen and a remainder of nitrogen, or a pure oxygen.

11. The method of manufacturing a high purity digallium trioxide according to any one of claims 7 to 10, wherein a purity of the metal gallium is 99.9999% by mass or more.

12. The method of manufacturing a high purity digallium trioxide according to any one of claims 7 to 11,
wherein a purity of the boron oxide is 99.999% by mass or more.
